# EUROPEAN PATENT SPECIFICATION

(11) **EP 0 458 483 B1**
(45) Date of publication and mention of the grant of the patent: **19.04.1995**
(21) Application number: 91304029.1
(22) Date of filing: 03.05.1991
(51) Int. Cl.: H01R 23/68, H01R 23/70

(54) **Improvements in or relating to connectors**
Verbesserungen in bezug auf Verbinder
Perfectionnements concernant des connecteurs

(30) Priority: 09.05.1990 GB 9010362
(43) Date of publication of application: 27.11.1991
(73) Proprietor: THOMAS & BETTS CORPORATION, Memphis, Tennessee 38119 (US)
(72) Inventor: Little, Philip V., High Wycombe, Buckinghamshire HP15 7JX (GB)
(74) Representative: Howick, Nicholas Keith

(56) References cited:
- EP-A- 0 254 385
- WO-A-87/07444
- DE-B- 2 329 476
- IEEE TRANSACTIONS ON COMPONENTS, HYBRIDS AND MANUFACTURING TECHNOLOGY V. CHMT-8, no. 4, December 1985, pages 530-534, New York,US; W.J. CLARK: "The PBC Connector as a Surface Mounted Device"

## Description

The invention relates to electrical connectors, and their manufacture. More particularly, the invention relates to connectors mounted on a substrate, such as a printed circuit board (hereinafter referred to as PCB) where contacts of a connector need to be connected electrically to an electrical circuit present on the PCB.

Connection of connector contacts to a circuit present on a PCB is usually achieved either by passing a leg of each contact through a hole in the PCB and then making electrical contact by soldering to a line of the circuit of the PCB present at the respective hole (referred to as "through hole mounted" connector), or by arranging an arm of each contact to lie against a respective desired point of the circuit of the PCB and to solder the contact arms in place (referred to as a "surface mounted" connector). In a surface mounted connector arrangement,a PCB generally has one or more rows of contact positions spaced to be compatible with the spacing of the contact arms of the connector to be surface mounted. A known technique for securing the contact arms to the desired points of the circuit of the PCB has been to use reflow soldering, where the connector is mounted on the PCB in a desired position, and the assembly heated in an oven to fuse each contact arm, by solder provided on the PCB, to the respective circuit. All soldered connections are thus achieved at the same visit to the heated oven.

With contacts being close together, problems can occur with interference, and there is a need for grounding or shielding to be provided between the contacts. This is achieved by providing grounding or shielding contacts. Such shielding or grounding contacts have, in reflow soldered assemblies, hitherto been provided after reflow soldering, using through hole soldering of the grounding or shielding contacts, or press-fit contacts. An example of a surface mounted computer with a ground plate is shown in EP-A-0254385 which discloses a shielded connector for surface connection to a printed circuit board, which connector comprises a body of insulating material, a multiplicity of electrical contacts, each contact having a first portion for making contact with or a contact of a mateable connector, in use, and a second portion to be connected to a surface of a printed circuit board, an electrically conductive shield being mounted on the body for shielding or grounding the contacts.

According to the invention there is provided a shielded connector for surface connection to a printed circuit board, which connector comprises a body of electrically insulating material, a multiplicity of electrical contacts, each contact having a first portion for making contact with a contact of a mateable connector, in use, and a second portion adapted to be connected to a surface of a printed circuit board, electrically conductive shielding contact means mounted on said body for shielding or grounding said electrical contacts, which shielding contact means comprise a plurality of electrically connected shielding finger contacts adapted to be connected to said printed circuit board surface, and hinge means for hingedly engaging the shielding contact means with the body at a location remote from the finger contacts, said hinge means including a rolled edge portion of the shielding contact means and lip means on said body. Connection of the electrical and finger contacts to the PCB can be simultaneous.

Each finger contact of the shielding contact means preferably passes between an associated pair of electrical contacts such that connections between said finger contacts and a printed circuit board, in use, lie nearer the edge of the printed circuit board than connections between the electrical contacts and the printed circuit board. An end portion of each finger contact preferably extends generally away from the printed circuit board connection locations of the electrical contacts.

The holding means may comprise tang means engageable with an abutment surface of the body such that, with the hinge means engaged, the holding means operates with a snap-fit once the tang means have moved past the abutment surface.

The electrical contacts are preferably arranged in at least one row and the finger contacts are preferably arranged in a row parallel to the or each row of electrical contacts.

The connector may have two sets of electrical contacts and shielding contact means, one set for contacting one side of a printed circuit board and the other set for contacting the other side of a printed circuit board.

The invention further provides a printed circuit board and a surface mounted connector according to the invention.

The invention further provides a method of surface mounting a shielded connector according to the invention comprising the steps of:-
(a) assembling the connector,
(b) providing on the printed circuit board solder pads at locations corresponding to the desired locations of the electrical contacts and the finger contacts on the board,
(c) engaging the connector with the printed circuit board such that the electrical contacts and the finger contacts lie against respective solder pads,
(d) heating the assembled connector and printed circuit board sufficiently to melt the solder, and
(e) cooling the assembly to fuse the solder.

The heating step is preferably carried out in an oven.

By way of example, one embodiment of a connector according to the invention will now be described with reference to the accompanying drawings, in which:-
Figure 1 is a perspective view of a connector according to the invention with a ground contact portion shown separately;
Figure 2 is a side view, partly in section, of the connector of Figure 1, illustrating location of the ground contact;
Figure 3 is a side view, partly in section, of the connector of Figures 1 and 2 mounted on a printed circuit board;
Figure 4 is a plan view illustrating an edge arrangement of edge contact locations of a PCB for through hole mounted and surface mounted connectors;
Figure 5 is a detail of Figure 5 shown on an enlarged scale; and
Figure 6 is a view of a PCB edge portion illustrating contact portions for a grounded or shielded connector as shown in Figures 1, 2 and 3.

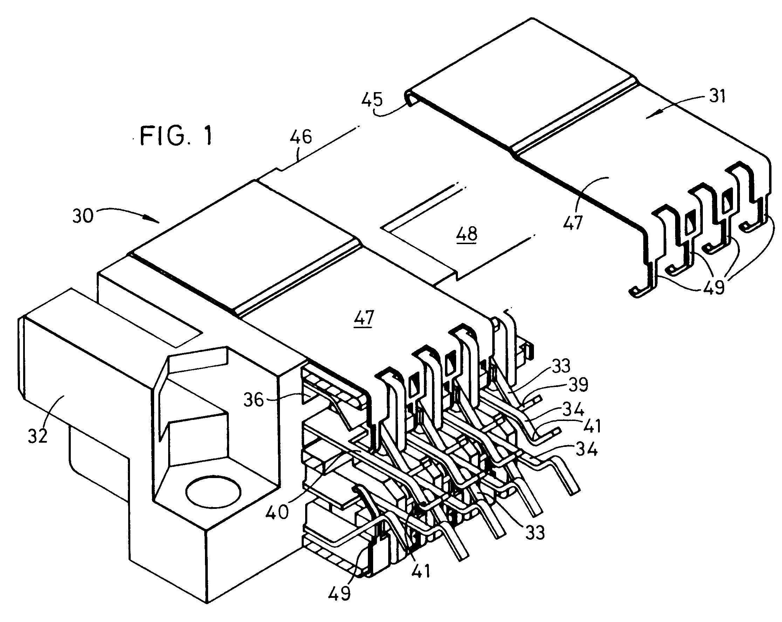

Figures 1, 2 and 3 show part of a female connector 30 for surface mounting on a PCB with a shielding or grounding contact 31. The connector 30 has a housing or body 32 moulded of plastics, or of other suitable material, with a set of openings 13 to allow access of contact pins of a male connector (not shown) into the female connector 30.

The connector 30 has contacts 33, 34 each with female contact portion 14 of a conducting material such as metal, and conveniently produced by stamping from a sheet and then bending to the desired shape. Each contact portion 14 has a pair of opposed, cantilevered legs 15, 16 extending from a web 17.

The contacts 33 and 34 have different configurations at the ends for attachment to a PCB 35, both types of contact 33 and 34 being of electrically conductive material, such as a metal, and conveniently made by stamping from a sheet of contact material and then bending. The contacts 33 and 34 are configured to have equal contact lengths from the PCB 35 to the female contact portions to avoid any difference in resistance.

The contacts 33 are arranged in the uppermost and lowermost rows in the body 32, and the contacts 34 are arranged in the middle rows in the body 32.

From the web 17, a contact arm 37 of each contact 33 passes through a passageway 36 in the body 32, the contact arm 37 having a portion 38 extending towards the PCB 35, and a V-shaped end portion 39, the base of the V-shaped end portion 39 of each contact 33 contacting and being soldered to a respective solder pad on the PCB 35 on a track to make a desired connection with the circuit on the PCB 35.

From the web 17, a contact arm 40 of each contact 34 extends parallel to the PCB 35, in use, the arm 40 of each contact 34 having a V-shaped end portion 41, the base of the V-shaped end portion 41 of each contact 34 contacting and being soldered to a respective pad on the PCB 35 on a track to make a desired connection with the circuit on the PCB 35.

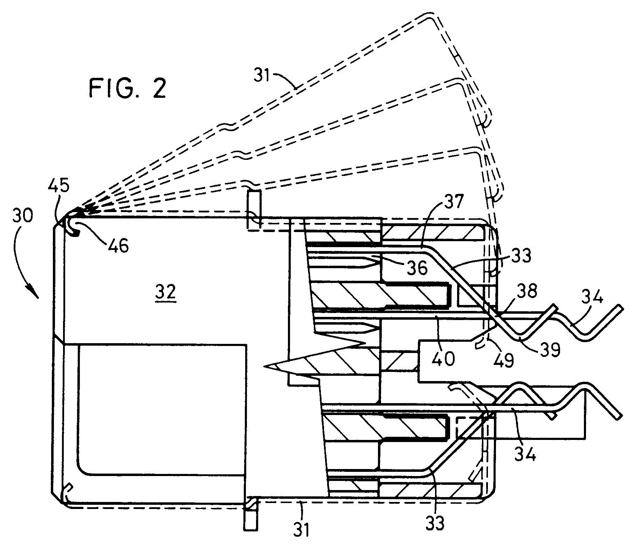

The grounding or shielding contact 31 is of suitable contact material, such as metal, and conveniently formed by stamping from a sheet, and bending. The contact 31 has a rolled edge 45 which engages a lip 46 on the body 32. As shown in Figure 2, after initial engagement of the rolled edge 45 and the lip 46, the contact 31 is rotated downwardly into its final position. The contact 31 has a planar portion 47 which is located in a recess 48 in the body 32, and finger contacts 49 which extend between the arms 37 and 40 of the contacts 33 and 34 to reach, in use, the PCB 35. A central pair of the finger contacts 49 have tangs 50 pushed out (one tang may be sufficient), which tangs 50 engage a lip 51 on the body with a snap-fit to hold the contact 31 on the body 32. It will be appreciated that the finger contacts could be formed with a hole, and the body moulded with an abutment surface to achieve the same snap-fit effect.

The connector 30 can thus be pre-assembled to the form shown in Figure 1 before engagement with the PCB 35. The assembled PCB 35 and connector 30 (or, indeed, more than one such connector 30) can be placed in an oven to heat the assembly to solder the contacts 33, 34 and 49 to respective solder pads by using standard surface mounting reflow soldering techniques. Such techniques are well known and will not be described in detail.

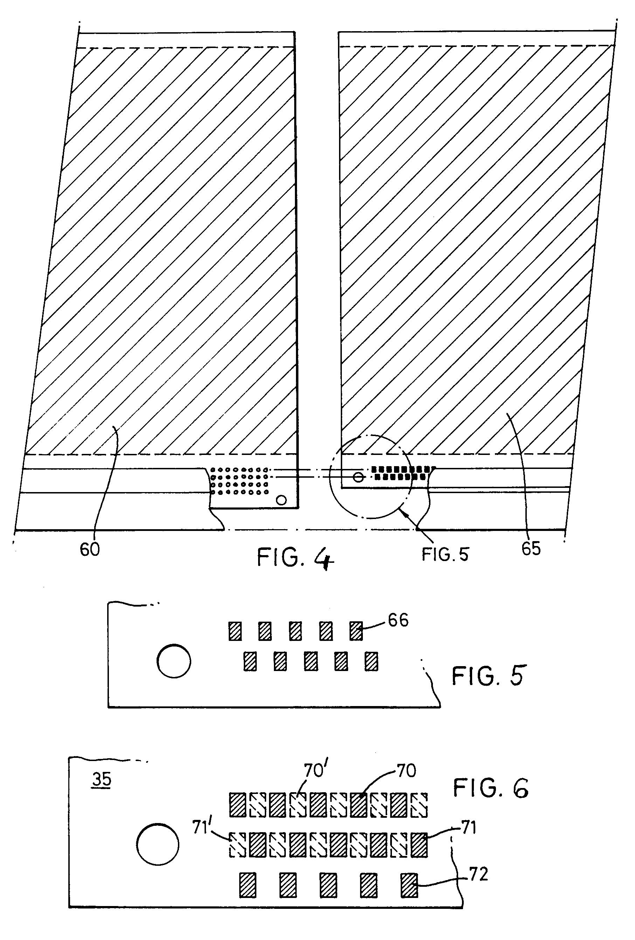

Figure **4** shows a comparison of contact positions in a through hole mounted PCB 60 and on one side of a surface mounted PCB 65. This illustrates that the usable surface of the two boards is the same,

Figure **5** shows a PCB solder contact pad detail for a PCB with a surface mounted connector without shielding or grounding. The contacts 33 and 34 lie against the pads 66 which, when heated to a requisite temperature, solder the respective contacts to the respective pads.

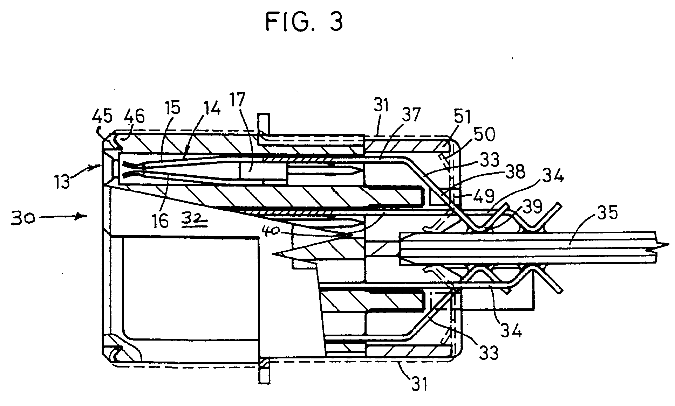

Figure **6** shows a plan view of solder pads on the PCB 35 shown in Figure **3** for use with the connector of Figures 1, 2 and **3**. On the side of the PCB shown in Figure **7**, there is an inner row of solder pads 70 for attachment to the contacts 34, a second row of solder pads 71 for attachment to the contacts 33, and a third row of solder pads 72 for attachment to grounding or shielding finger contacts 49. The solder pads 72 for ground or shield contacts are applied in corresponding positions above and below the PCB, but the solder pads 70 on one side of the PCB 35 lie between solder pads 70' on the other side of the PCB. Similarly, the solder pads 71 on one side of the PCB 35 lie between solder pads 71′ on the other side of the PCB.

This embodiment of a connector (while a female connector has been described mounted on the PCB, it will be appreciated that a male connector could equally well be so mounted) allows a surface mounted connector to be provided with grounding or shielding, in which the connections for the connector contacts and grounding/ shielding contacts can be made using surface mounting reflow soldering techniques instead of applying a ground contact row after reflow soldering by through hole soldering or press-fit contacts.

The ground contacts are outside the contacts 33, 34 with the PCB, so that grounding paths pass through the signal paths to enhance the grounding or shielding effects, and also allow no extra PCB space to be taken by the shield or grounding contacts.

Furthermore, the fact that the grounding or shielding contact fingers are brought down between the electrical contact fingers to the edge of the PCB allows the joints between the electrical contact fingers and the PCB to be visually inspected after soldering.

Various changes to the foregoing described and shown structures would be evident to those skilled in the art. Accordingly, the particularly disclosed invention is intended to be illustrative rather than limiting. The true scope of the invention is set forth in the Claims appended hereto.

## Claims

1. A shielded connector (30) for surface connection to a printed circuit board (35), which connector comprises a body (32) of electrically insulating material, a multiplicity of electrical contacts (33, 34), each contact having a first portion (16, 17) for making contact with a contact of a mateable connector, in use, and a second portion (38, 39; 40, 41) adapted to be connected to a surface of a printed circuit board (30), electrically conductive shielding contact means (31) mounted on said body for shielding or grounding said electrical contacts (33, 34), which shielding contact means (31) comprise a plurality of electrically connected shielding finger contacts (49) adapted to be connected to said printed circuit board surface, and hinge means (45) for hingedly engaging the shielding contact means (31) with the body (32) at a location remote from the finger contacts (49), said hinge means incuding a rolled edge portion (45) of the shielding contact means and lip means (46) on said body.

2. A connector as claimed in Claim 1 wherein each finger contact (49) of the shielding contact means (31) passes between an associated pair of electrical contacts (33, 34) such that connections between said finger contacts (49) and a printed circuit board (35), in use, lie nearer an edge of the printed circuit board than connections between the electrical contacts (33, 34) and the printed circuit board.

3. A connector as claimed in Claim 1 or Claim 2 comprising holding means (50, 51) intermediate the hinge means (45) and free ends of the finger contacts (49) for engaging the body (32) at one or more locations spaced apart from the hinge means to hold together the shielding contact means (31) and the body (32).

4. A connector as claimed in Claim 3 wherein the holding means comprise tang means (50) engageable with an abutment surface (51) of the body such that, with the hinge means engaged, the holding means operates with a snap-fit once the tang means (50) have moved past the abutment surface (51).

5. A connector as claimed in any one of Claims 1 to 4 wherein the electrical contacts (33, 34) are arranged in at least one row and the finger contacts (49) are arranged in a row parallel to the or each row of electrical contacts.

6. A connector as claimed in any one of Claims 1 to 5 comprising two sets of electrical contacts (33, 34) and shielding contact means (49), one set for contacting one side of a printed circuit board (35), and the other set for contacting the other side of a printed circuit board.

7. A connector and printed circuit board assembly comprising a printed circuit board (35) and a surface mounted connector (30) as claimed in any one of Claims 1 to 6.

8. A method of surface mounting a shielded connector as claimed in any one of Claims 1 to 7 on a printed circuit board (35), comprising the steps of:
(a) assembling the connector (30),
(b) providing on the printed circuit board solder pads (70, 71, 72) at locations corresponding to the desired locations of the electrical contacts (33, 34) and the finger contacts (49) on the board,
(c) engaging the connector (30) with the printed circuit board (35) such that the electrical contacts (33, 34) and the finger contacts (49) lie against respective solder pads,
(d) heating the assembled connector and printed circuit board sufficiently to melt the solder, and
(e) cooling the assembly to fuse the solder, whereby the electrical contacts and the finger contacts are simultaneously connected to the solder pads on the printed circuit board.

9. A method as claimed in Claim 8 wherein the heating step is carried out in an oven.

## Patentansprüche

1. Ein abgeschirmter Verbinder (30) zum Oberflächen-Anschluß an eine Leiterplatte (35), wobei der Verbinder einen Körper (32) aus einem elektrisch isolierenden Material, eine Vielzahl von elektrischen Kontakten (33, 34), von denen jeder einen ersten Abschnitt (16, 17) zum Ausbilden eines Kontaktes mit einem Kontakt eines dazu passenden Verbinders bei Gebrauch und einen zweiten Abschnitt (38, 39; 40, 41), der mit einer Oberfläche einer Leiterplatte (30) verbindbar ist, und ein elektrisch leitendes abschirmendes Kontaktmittel (31) aufweist, das auf dem Körper zum Abschirmen oder Erden der elektrischen Kontakte (33, 34) befestigt ist, wobei das abschirmende Kontaktmittel (31) eine Vielzahl von elektrisch verbundenen abschirmenden Fingerkontakten (49), die mit einer Leiterplattenoberfläche verbindbar sind, und ein Gelenkmittel (45) zur gelenkigen Verbindung des abschirmenden Kontaktmittels (31) mit dem Körper (32) an einer von den Fingerkontakten (49) abgelegenen Stelle aufweist, wobei das Gelenkmittel einen gerollten Kantenabschnitt (45) des abschirmenden Kontaktmittels und Lippenmittel (46) auf dem Körper enthält.

2. Ein Verbinder, wie in Anspruch 1 beansprucht, wobei jeder Fingerkontakt (49) des abschirmenden Kontaktmittels (31) zwischen einem zugehörigen Paar von elektrischen Kontakten (33, 34) derart durchtritt, daß Verbindungen zwischen den Fingerkontakten (49) und einer Leiterplatte (35) bei Gebrauch näher an einer Kante der Leiterplatte als Verbindungen zwischen den elektrischen Kontakten (33, 34) und der Leiterplatte liegen.

3. Ein Verbinder, wie in Anspruch 1 oder Anspruch 2 beansprucht, mit Haltemitteln (50, 51) zwischen dem Gelenkmittel (45) und freien Enden der Fingerkontakte (49) zum Erfassen des Körpers (32) an einer oder mehreren vom Gelenkmittel abgelegenen Stellen zum Zusammenhalten des abschirmenden Kontaktmittels (31) und des Körpers (32).

4. Ein Verbinder, wie in Anspruch 3 beansprucht, wobei die Haltemittel ein mit einer Auflagerfläche (51) des Körpers in Anlage bringbares Griffmittel (50) derart aufweisen, daß das Haltemittel bei in Anlage befindlichem Gelenkmittel mit einem Schnapp-Sitz arbeitet, sobald das Griffmittel (50) sich an der Auflagerfläche (51) vorbei bewegt hat.

5. Ein Verbinder, wie in irgendeinem der Ansprüche 1 bis 4 beansprucht, wobei die elektrischen Kontakte (33, 34) in mindestens einer Reihe angeordnet sind und die Fingerkontakte (49) in einer zu der Reihe oder zu jeder Reihe der elektrischen Kontakte parallelen Reihe angeordnet sind.

6. Ein Verbinder, wie in irgendeinem der Ansprüche 1 bis 5 beansprucht, mit zwei Sätzen von elektrischen Kontakten (33, 34) und einem abschirmenden Kontaktmittel (49), ein Satz zum Kontaktieren einer Seite einer Leiterplatte (35) und der andere Satz zum Kontaktieren der anderen Seite einer Leiterplatte.

7. Eine Verbinder- und Leiterplattenanordnung mit einer Leiterplatte (35) und einem oberflächenmontierten Verbinder (30), wie in irgendeinem der Ansprüche 1 bis 6 beansprucht.

8. Ein Verfahren zur Oberflächenmontage eines abgeschirmten Verbinders, wie in irgendeinem der Ansprüche 1 bis 7 beansprucht, auf einer Leiterplatte (35), umfassend die Stufen:
(a) Zusammenbauen des Verbinders (30),
(b) Ausbilden von Lötkissen (70, 71, 72) auf der Leiterplatte an Stellen entsprechend den gewünschten Stellen der elektrischen Kontakte (33, 34) und der Fingerkontakte (49) auf der Platte,
(c) Anlegen des Verbinders (30) an die Leiterplatte (35) derart, daß die elektrischen Kontakte (33, 34) und die Fingerkontakte (49) an den betreffenden Lötkissen anliegen,
(d) Aufheizen des zusammengebauten Verbinders und der Leiterplatte in zum Schmelzen des Lotes ausreichendem Maß und
(e) Abkühlen der Anordnung zum Verschmelzen des Lotes, wodurch die elektrischen Kontakte und die Fingerkontakte gleichzeitig mit den Lötkissen auf der Leiterplatte verbunden werden.

9. Ein Verfahren, wie in Anspruch 8 beansprucht, wobei die Heizstufe in einem Ofen durchgeführt wird.

## Revendications

1. Connecteur blindé (30) pour montage en surface sur une carte de circuit imprimé (35), lequel connecteur comprend un corps (32) constitué d'un matériau électriquement isolant, une multiplicité de contacts électriques (33, 34), chaque contact comportant une première partie (16, 17) destinée à entrer en contact avec un contact d'un connecteur jumelable, lors de l'utilisation et une seconde partie (32, 39 ; 40, 41) conçue pour être reliée à une surface d'une carte de circuit imprimé (30), un moyen de contact de blindage électriquement conducteur (31) monté sur ledit corps pour assurer le blindage ou la mise à la masse desdits contacts électriques (33, 34), lequel moyen de contact de blindage (31) comporte une pluralité de contacts à doigts de blindage reliés électriquement (49) conçus pour être reliés à ladite surface de carte de circuit imprimé, et un moyen de charnière (45) destiné à engager le moyen de contact de blindage (31) d'une manière pivotante avec le corps (32) en un emplacement distant des contacts à doigts (49), ledit moyen de charnières incluant une partie de bord recourbée (45) du moyen de contact de blindage et un moyen de lèvres (46) sur ledit corps.

2. Connecteur selon la revendication 1, dans lequel chaque contact à doigts (49) du moyen de contact de blindage (31) passe entre une paire de contacts électriques associée (33, 34) d'une manière telle que les zones de jonction entre lesdits contacts à doigts (49) et la carte de circuit imprimé (35) lors de l'utilisation, sont situées plus près d'un bord de la carte de circuit imprimé que les zones de jonction entre les contacts électriques (33, 34) et la carte de circuit imprimé.

3. Connecteur selon la revendication 1 ou la revendication 2 comprenant un moyen de maintien (50, 51) intermédiaire entre le moyen de charnière (45) et les extrémités libres des contacts à doigts (49) pour engager le corps (32) en un ou plusieurs emplacements espacés du moyen de charnière afin de maintenir ensemble le moyen de contact de blindage (31) et le corps (32).

4. Connecteur selon la revendication 3, dans lequel le moyen de maintien comprend un moyen de tenon (50) qui peut venir s'engager avec une surface de butée (51) du corps d'une manière telle que, le moyen de charnière étant engagé, le moyen de maintien agisse par encliquetage après que le moyen de tenon (50) ait dépassé la surface butée (51).

5. Connecteur selon l'une quelconque des revendications 1 à 4, dans lequel les contacts électriques (33, 34) sont disposés en une rangée au moins et dans lequel les contacts à doigts (49) sont disposés sur une rangée parallèle à la rangée de contacts électriques ou à chacune d'entre elles.

6. Connecteur selon l'une quelconque des revendications 1 à 5, comprenant deux ensembles de moyens de contacts électriques (33, 34) et de contacts de blindage (49), un premier ensemble étant destiné à entrer en contact avec un premier côté de la carte de circuit imprimé (35) et l'autre ensemble étant destiné à entrer en contact avec l'autre côté de la carte de circuit imprimé.

7. Montage de connecteur et de carte de circuit imprimé comprenant une carte de circuit imprimé (35) et un connecteur monté en surface (30) selon l'une quelconque des revendications 1 à 6.

8. Procédé pour monter en surface un connecteur blindé selon l'une quelconque des revendications 1 à 7 sur une carte de circuit imprimé (35), comprenant les étapes consistant à :
(a) assembler le connecteur (30),
(b) disposer sur la carte de circuit imprimé des plots de soudure (70, 71, 72) à des emplacements correspondant aux emplacements souhaités des contacts électriques (33, 34) et des contacts à doigts (49) présents sur la carte,
(c) engager le connecteur (30) avec la carte de circuit imprimé (35) d'une manière telle que les contacts électriques (33, 34) et les contacts à doigts (49) reposent contre des plots de soudure respectifs,
(d) chauffer le connecteur et la carte de circuit imprimé assemblés d'une manière suffisante pour fondre la soudure, et
(e) refroidir le montage pour fusionner la soudure, d'où il résulte que les contacts électriques et les contacts à doigts sont reliés simultanément aux plots de soudure sur la carte de circuit imprimé.

9. Procédé selon la revendication 8, dans lequel l'étape de chauffage est exécutée dans un four.
